# EUROPEAN PATENT APPLICATION

(11) **EP 4 403 676 A1**
(43) Date of publication of application: **24.07.2024**
(21) Application number: 23152526.2
(22) Date of filing: 19.01.2023
(51) Int. Cl.: C25F 5/00, C25F 7/00, H01L 21/00

(54) **ELECTRO-ETCHING METHOD FOR AN AREA-SELECTIVE TREATMENT OF A SUBSTRATE**

(71) Applicant: Semsysco GmbH, 5020 Salzburg (AT)
(72) Inventor: ÖTZLINGER, Herbert, 5300 Hallwang (AT); OKORN-SCHMIDT, Harald, 8020 Graz (AT); KOLITSCH-MATALN, Marianne, 9500 Villach (AT); REICHENPFADER, Manuel, 1220 Wien (AT); PÖCHEIM, Alexander, 5020 Salzburg (AT)
(74) Representative: Maiwald GmbH

(57) **Abstract**

The application relates to an electro-etching method for an area-selective treatment of a substrate and an electro-etching system for an area-selective treatment of a substrate.

The electro-etching method for an area-selective treatment of a substrate comprises:
providing a substrate comprising a surface at least partially covered by at least one electrically conductive material and structures at least partially formed by the electrically conductive material, so that the structures are electrically connected by means of the electrically conductive material covering the surface,
covering the substrate with an electrolyte,
applying an electric potential to the substrate,
electro-etching the electrically conductive material by means of a combination of the electric potential and the electrolyte, and
continuing the electro-etching until the electrically conductive material at the surface is removed so that the structures are no longer electrically connected by means of the electrically conductive material covering the surface.

## Description

### Technical field

The application relates to an electro-etching method for an area-selective treatment of a substrate and an electro-etching system for an area-selective treatment of a substrate.

### Background

Wet chemical etching of materials is carried out by immersing a substrate into an etchant or electrolyte, which consists usually of one or several mixed chemicals. These chemicals are usually capable of reacting individually or combined with the material to dissolve it from the solid state into the liquid matrix. For etching oxidized materials e.g. SiO₂, CuO/Cu₂O, TiO₂, and similar, an electron transfer is not required, accordingly it is usually sufficient to only apply a chemical solvent. A solvent exchanges an oxygen in the material by another anion, e.g. chloride, fluoride, sulfate and similar, to create a more soluble compound compared to an oxide. This process can be carried out by common acids or bases like HCl, HF, H₂SO₄, NaOH, KOH, and similar, or mixtures thereof. On the other hand, for some materials, such as metals like Cu, Ni, Ag, etc., or semiconductors (Si, Ge, GaN, GaAs, etc.), an additional electron transfer process is required to oxidize the metallic surface atoms to corresponding metal-ions, which then can be made soluble by e.g., complexing with a specific ion. In such classical metal etch processes, a combination of two sub-processes may be required, one being an oxidation or electron extraction process from the metallic surface followed by a second sub-process, which is a solvation or complexation process forming the soluble metal ion compound with a specific anion.

Etching semiconductor substrates may necessitate specific process requirements such as high-speed etching with high precision in thickness control (atomic level precision), and a high uniformity over a large substrate area. These requirements may be met by using complex chemical mixtures containing e.g., an oxidizer (like H₂O₂, O₃, persulfate and similar) and an acid or base to provide an anion for dissolution. Nevertheless, such chemicals are usually expensive in buying and waste treatment. Further, they are often instable, such that they cannot be stored for a long period or may start to decompose during use, making it complicated to maintain in the required concentration mix due to unequal consumption, product build up and/or faster evaporation of a component within the mixture.

Furthermore, many industrial production processes, especially in the very complex and atomic-scale-sensitive semiconductor device industry, require the ability to etch materials selectively. Selectivity may mean that only structures at a selected area of the substrate needs to be processed. This is particularly important when the treated substrate comprises structures such as ridges, vias and/or trenches. Such substrates, where materials are electrochemically deposited onto or into these structures, may also require a seed layer to be deposited over the structures as well as between the structures in order to provide a conductive layer. After the deposition process, when all structures are covered, the conductive material between these structures needs to be removed (including in most cases the seed layer) without etching the material on or inside the structures, to eliminate any risks for electrical short cuts. This is not yet possible. Etching substrates with chemicals, which are oxidizing and dissolving at the same time, remove all material layers of the same nature with the same rate. A targeted etching of specific surface areas of a substrate is not yet possible.

### Summary

Hence, there may be a need to provide an etching method for an area-selective treatment of a substrate, which allows a secure removal of an electrically conductive material only at specific surface areas of a substrate.

The problem is solved by the subject-matters of the independent claims, wherein further embodiments are incorporated in the dependent claims. It should be noted that the aspects of the disclosure described in the following apply to the electro-etching method for an area-selective treatment of a substrate and the electro-etching system for an area-selective treatment of a substrate.

According to the present disclosure, an electro-etching method for an area-selective treatment of a substrate is presented. The electro-etching method comprises the following steps not necessarily in this order.
- Providing a substrate comprising a surface and structures. The surface is at least partially covered by at least one electrically conductive material. The structures are at least partially formed by the electrically conductive material, so that the structures are electrically connected by means of the electrically conductive material covering the surface.
- Covering the substrate with an electrolyte.
- Applying an electric potential to the substrate.
- Electro-etching the electrically conductive material by means of a combination of the electric potential and the electrolyte.
- Continuing the electro-etching until the electrically conductive material at the surface is at least partially removed so that the structures are no longer electrically connected by means of the electrically conductive material covering the surface.

In other words, the substrate may have not a flat continuous surface, but a surface with 3D structures, as for example mountains and/or valleys. Everything may be covered by the electrically conductive material, which thereby forms an electrically conductive cover or coating for the substrate. The electrically conductive cover electrically connects the entire substrate surface as well as the mountains and/or valleys. Only when a combination of electrolyte and electric potential is applied, the electrically conductive material begins to be removed. This continues until the electrically conductive cover is at some position at least partially removed or disrupted and the electrical connection is thereby interrupted. Accordingly, an electric flux through the surface may become zero (causing a floating electric potential) and, consequently, the entire electro-etching process stops automatically. As a result, an area-selective etching of the substrate is made possible. In most cases, the electrically conductive material covering the surface is removed and the electrically conductive material forming the (3D) structures is only reduced. The mountains and/or valleys made from or filled by the electrically conductive material are still present, nevertheless their topographies may change.

The electro-etching method of the present disclosure has many advantages over the prior art. By regulating the amount of flowing current (applied potential), an exact number of electrons can be extracted from the material and with this an exact amount of oxidation can be provided. Thereafter, the exact amount of oxidized material may be dissolved/complexed into the electrolyte solution, preferably by an anion from the electrolyte. It may be therefore possible to sensitively control an amount of electrically conductive material being etched on the substrate surface.

Furthermore, different to electrochemical potentials of chemical oxidizers, by applying higher potentials, very specific oxidation processes can be achieved and etch processes with much higher speed can be performed. Applying lower potentials, on the other hand, can help in obtaining a better process control and a better uniformity.

Another advantage of the electro-etching method of the present disclosure is that the electrolyte can be designed to be very simple, cheap, and time stable, without requiring containing a complex oxidizing medium. For instance, the electrolyte may comprise just one component of an acid or a base, or a simple combination of two acids or two bases or more. Accordingly, the electrolyte can be safely applied in high quantities, for instance to very large substrates. Thus, the present method is flexible in application to various sized and shaped substrates.

The substrate may be a plate shaped substrate, round, square or may have any other shape. The dimensions of the substrate may extend in the range of a few to several thousand millimeters. The electro-etching method may be used to treat a single side or both sides of the substrate. The electrically conductive material may comprise any metal, for instance copper. Accordingly, the present electro-etching method may be applied to a substrate that is electroplated with copper.

The electro-etching method of the present disclosure requires usage of an electrolyte and application of an electric potential to the to-be-etched substrate. The electrolyte may contain at least one acid component, which by itself may not etch the conductive material layer on the substrate, without the presence of an electric potential. In order for the electro-etching method to work, an electric potential is applied to the substrate. The electric potential may be, for instance, an anodic potential. With the presence of the electric potential and the electrolyte, the electro-etching process may be started, preferably layer by layer, starting from an outermost layer towards the substrate surface. By this, the outermost electrically conductive material layer (and a seed layer, if provided) is reduced until completely dissolved, leaving the substrate surface free (especially between the structures).

In an embodiment, the structures are ridges comprising the electrically conductive material. In other words, the structures may be mountains or protrusions made of the electrically conductive material and extending from a substrate surface in height (+Z) direction. The ridges can be understood as structures extending from the substrate surface in a direction above the substrate surface (+Z direction). The structures may be for instance pillars, lines or the like. The ridges may be made of or covered by the electrically conductive material at all sides of the ridges.

In an embodiment, the structures are trenches at least partially filled with the electrically conductive material. In other words, the structures may be valleys, vias, grooves or depressions, extending below the substrate surface in the opposite (-Z) direction. Trenches shall be understood as structures extending in a direction below the substrate surface (-Z direction). Trenches may be in the form of an elongated slit on the surface of the substrate, as well as may be smaller in length, thereby forming only a spot. The trenches may be preferably filled with the electrically conductive material at least until a surface level of the substrate. Preferably, the trenches may be filled completely with the electrically conductive material, such that an upper part of the material is at the surface level. Optionally, the electrically conductive material may overflow the trenches, such that the material at least partially exceeds the surface level.

Of course, the structures may have a 3-dimensional form that may extend also in an X and a Y direction on the substrate surface. The structures may have a constant height or may have an increasing or decreasing height in at least one of the X or Y direction.

The electro-etching method of the present disclosure is especially advantageous when used to electro-etch substrates comprising such trenches or ridges. By the presented method, the ridges or trenches, which are connected through the electrically conductive material on the substrate surface, will be electrically isolated by electro-etching and removing the material layer in-between the ridges and trenches. The material layers inside the trenches or on top of the ridges may be reduced, but (main) parts may remain unetched. This cannot be achieved by conventional chemical etching processes, in which the material will be completely etched away without any possibility for selectivity. More detail is given below.

In an embodiment, the electro-etching is essentially stopped with a removal of the at least one electrically conductive material covering the surface between the structures. In this embodiment, electro-etching may be stopped when the substrate surface is reached, in other words, when all layers constituting the electrically conductive material are removed. The electro-etching may be done anisotropically in the +Z or -Z direction, until Z=0 is reached. By removing the conductive material until the Z=0 position, the structures may be isolated from each other. Stopping of electro-etching may be automatic, in that electro-etching may not continue further because there is no more electrically conductive material left between the structures (for instance when there is no more electrically conductive material left between the ridges or trenches, although the ridges or the trenches may still comprise electrically conductive material). This may proceed layer by layer towards the Z=0 position. As a summary, the electro-etching is stopped with the removal of the at least one electrically conductive material covering the surface between the structures. The at least one electrically conducting material forming the structures may no longer be removed. During the removal of the at least one electrically conductive material covering the surface between the structures, the at least one electrically conducting material in the structures, trenches or ridges may only be reduced and not significantly removed.

Alternatively, stopping of electro-etching may be controlled externally. Some options for external control may be by cancelling the application of the electric potential to the substrate or preventing the contact of the electrolyte to the substrate. External control for stopping electro-etching may be useful for not completely removing the structures of the substrate. This means electro-etching may be stopped before the electrically conductive material is completely removed from the substrate surface (for instance, when there is still at least a layer of electrically conductive material remaining on the substrate surface or between the trenches or ridges). Alternatively, the structures may be completely removed from the substrate surface.

In an embodiment, the electrically conductive material covering the surface of the substrate is essentially the same as the electrically conductive material forming the structures.

In an embodiment, the electric potential extracts electrons from the electrically conductive material to oxidize the electrically conductive material electrically to obtain an electrically oxidized material surface. In an embodiment, the electrolyte dissolves the electrically oxidized material surface.

In an embodiment, the availability of the electrolyte is reduced in areas of high electric flux (thus high electromagnetic field) to balance the electro-etching relative to areas oflower electromagnetic field. For instance, if the electric potential is applied at the edges of the substrate, this may cause increased electric flux and higher electromagnetic field at the edges of the substrate, compared to for instance a central part. In this case, it could be of advantage to limit the presence of electrolyte around these areas and enhance chemical activity more elsewhere (i.e. in a center of the substrate (or corresponding part of the substrate holder)) to balance an etching rate. Accordingly, high or low electromagnetic field may be easily compensated by locally controlling an amount of electrolyte.

In an embodiment, the electrolyte is essentially not chemically oxidizing the electrically conductive material. In another embodiment, the electrolyte is passivating the electrically conductive material forming the structures after the electrically conductive material covering the surface between the structures has been removed. In this embodiment, the electrolyte may comprise a passivating component that passivates the structures, before and/or after the structures are isolated from each other by removing the electrically conductive material between the structures. Passivation may help restoring corrosion resistance of the substrate, especially at the treated structures.

According to the present disclosure, also an electro-etching system for an area-selective treatment of a substrate is presented. The electro-etching system comprises:
- a substrate holder configured to hold the substrate and provide an electric potential to the substrate to form an anode,
- a cathode,
- an electrolyte configured to cover the substrate holder (and the substrate), and
- a distribution body.

The distribution body comprises electric potential distribution vias to distribute the electric potential relative to the substrate holder. The distribution body comprises chemical dissolution distribution vias to distribute the electrolyte relative to the substrate holder to electro-etch at least one electrically conductive material covering at least partially at a surface of the substrate and forming at least partially structures of the substrate by means of a combination of the electric potential and the electrolyte.

The electric potential distribution vias of the distribution body may enable a local tuning of electric potential distribution across the substrate holder (accordingly, across the substrate surface held by the substrate holder) to optimize the uniformity of the etching process. The chemical dissolution distribution vias are configured to distribute the electrolyte onto the substrate holder (accordingly, specific regions of the substrate surface held by the substrate holder). High uniformities and speeds can be achieved by the additional implementation of a high-speed distribution body, which is then used for distributing the electric potential and the electrolyte over the substrate holder in an optimized way. With the distribution body (high-speed or not), a targeted electro-etching on specific structures on the substrate may be performed, which may not be possible with an only chemical etching system.

The electro-etching system comprises a substrate holder, which might hold the substrate. The substrate holder may be a particular component for holding the substrate, but may be also a part of the anode to place the substrate directly onto the anode. The substrate holder may have any size and shape suitable for holding any kind of substrate. The substrate holder, next to holding the substrate to be etched stably, may provide an anode function by providing electric potential directly to the substrate. Electrons from the electrically conductive material at the surface of the substrate can be extracted through the potential being applied.

In an embodiment, the substrate holder is electrically connected to a positive pole of a source of direct electric current.

In an embodiment, the substrate holder comprises a plurality of electric contacts for the substrate. The electric contacts may be distributed evenly on the substrate holder, preferably at a circumference of the substrate holder. Nevertheless, when the substrate holder is in an angular form, the number of electric contacts do not need to be equal on all edges. The electric contacts may also be present on a single side (face) or on both sides (opposite faces) of the substrate holder. In the case of both sides, the substrate holder may be configured to carry two substrates, one being on each side.

In another embodiment, the substrate holder comprises one electric contact for the substrate and is essentially of the same size as the substrate. The single electric contact may be a full-surface contact or contact the substrate at least partially.

The electric contact(s) may be wet or dry contacts.

In an embodiment, the cathode is electrically connected to a negative pole of the source of direct electric current. In an embodiment, the cathode is made of an inert material to reduce unwanted electrochemical effects. In an embodiment, the cathode is made of a material insoluble in the electrolyte, e.g., Pt, Ni/IrO₂, or similar.

The electro-etching system may further comprise an electro bath or reservoir for containing the electrolyte. The electrolyte may be specifically optimized for the electrically conductive material to be etched.

In an embodiment, the chemical dissolution distribution vias comprise jet holes for controlling a flow of the electrolyte towards the substrate holder. The jet holes may have a structure or form to increase a speed of the distributed electrolyte. The jet holes may extend through a cross section of the distribution body, connecting opposite faces thereof (in a through hole form). In a more preferred embodiment, the jet holes may be supplied with the electrolyte from a liquid intake present at a side, at an edge or at least partially at a circumference of the distribution body. In other words, every jet hole may be connected to the liquid intake. The jet holes may then not connecting opposite faces of the distribution body in a through hole form. Instead, the jet holes may open to the liquid intake from a first side and open to the substrate holder from a second side of the distribution body, preferably essentially perpendicular to the first side. The jet holes may have an angular form.

In an embodiment, the chemical dissolution distribution vias comprise drain holes for controlling a draining off the electrolyte from the substrate holder. The drain holes may have a structure to provide a single way electrolyte distribution away from the substrate holder. In an embodiment, the electric potential distribution vias are the drain holes. The drain holes may extend through a cross section of the distribution body, connecting opposite faces thereof (in a through hole form). Alternatively, the distribution body may also have a liquid outlet. In this case, drain holes may open to the liquid outlet from one side and open to the substrate holder from another side of the distribution body.

In an embodiment there may be for each jet hole at least one drain hole, preferably directly adjacent thereto. It may also be possible to have more drain holes allocated to a jet hole for a faster discharge of the chemical dissolution away from the substrate holder or at a higher volume. Similarly, for an increased rate of electro-etching with less electrolyte, the number of jet holes may be higher than the number of drain holes. The drain holes may be arranged around the jet hole or vice versa. The jet holes and/or drain holes may enable a local tuning of electrolyte delivery across the substrate holder. Accordingly, a better material diffusion rate control can be provided. Further, the jet holes and/or drain holes may limit the availability of the electrolyte around specific areas, such as high power distribution areas.

In an embodiment, a netted distribution framework is arranged between the distribution body and the substrate holder. The appearance of the netted distribution framework may optically remind of a 3D net, e.g. a polymer net. The netted distribution framework comprises passages as electric potential distribution vias to distribute the electric potential relative to the substrate holder and chemical dissolution distribution vias to distribute the electrolyte relative to the substrate holder. The netted distribution framework may be understood as multiple passages connected to each other to provide a wide distribution of the transferred electrolyte with or without the electric potential. The passages may be arranged in a random manner to provide a non-concentrated distribution of the electrolyte. The number of passages may be different. For instance, the number of electric potential distribution vias may be higher compared to the number of chemical dissolution distribution vias. Alternatively, for each electric potential distribution via, there may be a chemical dissolution distribution via, preferably present adjacent to teach other. The passages of the electric potential distribution vias may have a straight form whereas the passage of the chemical dissolution distribution vias may be angled. With this, a direct contact of the chemical dissolution to the substrate held by the substrate holder may be prevented while electric potential may be manipulated in a controlled way. The netted distribution framework may accordingly provide an optimized distribution and accordingly an optimized electro-etching on the structures of the substrate. Nevertheless, it may be possible to arrange the passages of the netted distribution framework to concentrate the electrolyte discharge to specific areas of the substrate holder. With this, local tuning of the etching process may be provided. In either the concentrated or randomized distribution form, the netted framework may provide a distribution with less energy loss, compared to usage of, for instance a sponge or similar material.

In an embodiment, the distance between the substrate holder and the distribution body or the netted distribution framework is in a range of 5 to 50 mm, preferably 8 to 45 mm, more preferably 10 to 40 mm.

Therefore, a wet-chemical etching process is highly desired, which permits selective etching of a material depending on the location, where the material is deposited.

As a summary, a method and system of wet chemically etching material layers in-between structures (e.g. filled deep vias and trenches) is provided without significantly etching the material inside the deep vias and trenches. With this technique, potential electrical shorts are eliminated very effectively for further processing and in the applications of these substrates for electronic devices. Especially metallic or semiconducting material layers or non-oxidized material layers can be etched very effectively by this technique. It is possible to enable enormous selectivity of etching in-between different layers of the same material (area-selective etching), reduce the amount of chemical required for processing, eliminate the need of complex and time-instable chemical mixtures, eliminate the need for oxidizing chemical components, reduce the complexity and cost of chemical waste treatment, increase the chemical safety of the process, improve process control (especially the etch amount/atomic precision), increase the processing speed (for many processes), increase the options for selective etching, significantly improve the uniformity by enabling a local tuning of the power distribution across the substrate surface (electro-oxidation reaction rate control) and/or a local tuning of chemical dissolution speed and material transport phenomena across the substrate surface (material diffusion rate control).

It shall be understood that the method and the system according to the independent claims have similar and/or identical preferred embodiments, in particular, as defined in the dependent claims. It shall be understood further that a preferred embodiment of the disclosure can also be any combination of the dependent claims with the respective independent claim.

These and other aspects of the present disclosure will become apparent from and be elucidated with reference to the embodiments described hereinafter.

### Brief description of the drawings

Exemplary embodiments of the disclosure will be described in the following with reference to the accompanying drawings:
- Figure 1: shows schematically and exemplarily an embodiment of a substrate holder of an electro-etching system for an area-selective treatment of a substrate according to the disclosure.
- Figure 2: shows schematically and exemplarily an embodiment of a substrate before and after application of an electro-etching method for an area-selective treatment of a substrate according to the disclosure.
- Figures 3a and 3b: show schematically and exemplarily an embodiment of a substrate during application of an electro-etching method for an area-selective treatment of a substrate according to the disclosure.
- Figure 4: shows schematically and exemplarily an embodiment of an electroetching method for an area-selective treatment of a substrate according to the disclosure.

### Detailed description of embodiments

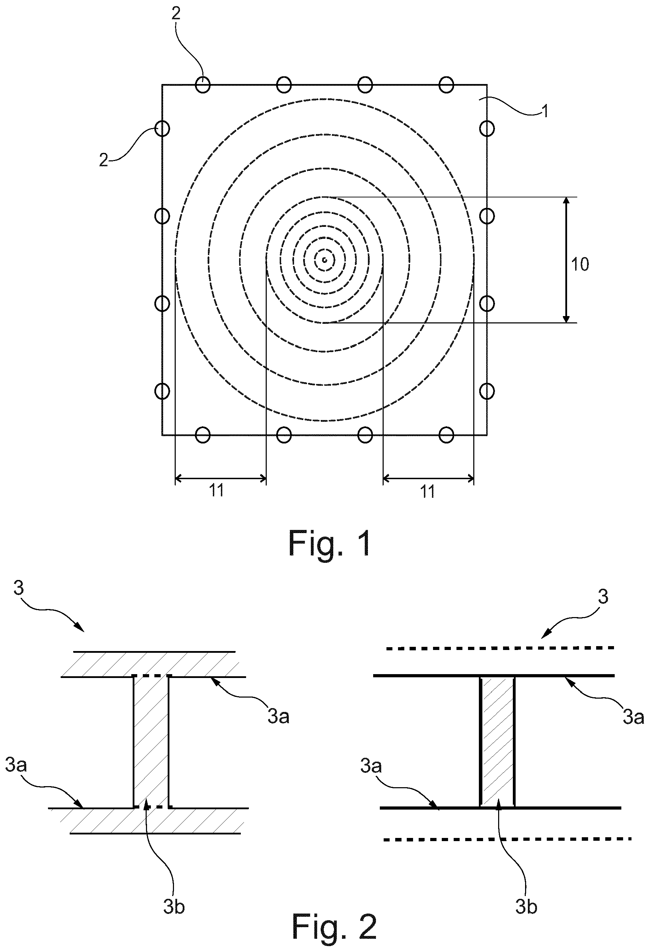

**Figure 1** shows schematically and exemplarily an embodiment of a substrate holder 1 of an electro-etching system for an area-selective treatment of a substrate 3 according to the disclosure.

In electro-etching systems, a substrate 3 to be electro-etched (not shown) is attached to the substrate holder 1, which is configured to hold the substrate 3 and provide an electric potential to the substrate 3 to form an anode. The substrate holder 1 shown in Figure 1 has a square shape, but it may have any size and shape corresponding to the substrate to-be-etched. The substrate holder 1, next to holding the substrate 3, provides an anode function by providing electric potential directly to the substrate 3 (not shown). For this, the substrate holder 1 comprises a plurality of electric contacts 2 configured to be connected to the substrate 3. The electric contacts 2 are distributed at a circumference on the substrate holder 1.

The availability of the electrolyte is reduced in areas of high electromagnetic field 11 (by the high electric flux caused by the electric contacts 2) to balance the electro-etching relative to areas of low(er) electromagnetic field 10 (in other words, areas away from an influence of the electric contacts 2). The areas of high electromagnetic field 11 are around the edges of the substrate 3. In this case, it is of advantage to limit the presence of electrolyte around the high electromagnetic field areas 11 and enhance chemical activity more in a center of the substrate 3 (at the areas of the substrate holder 1 corresponding to a center of the substrate) having lower electromagnetic field to increase an etching rate therein. In Figure 1, the dotted lines are depicting an intensity of the electrolyte applied to the areas of low and high electromagnetic field 10, 11, respectively. Here the terms high and low are defined to be relative to each other. Independent on the (numerical) value of the electromagnetic fields, a high electromagnetic field 11 refers to a value higher than the value of the low electromagnetic field 10, and a low electromagnetic field 10 refers to a value lower than the value of the high electromagnetic field 10.

**Figure 2** shows schematically and exemplarily an embodiment of a substrate 3 before (on the left side, with connected structures) and after (on the right side, with isolated structures) the application of the present electro-etching method for an area-selective treatment of a substrate 3.

Before electro-etching, as shown on the left hand side, the substrate 3 comprises two surfaces 3a at least partially covered by at least one electrically conductive material and a structure 3b at least partially formed (and/or filled, covered) by the electrically conductive material, so that the surfaces 3a are electrically connected by means of the electrically conductive material of the structure 3b. The substrate 3 may have multiple structures 3b arranged on the substrate 3 which are not shown in Figure 2. These structures 3b are initially electrically connected by the electrically conductive material on the surfaces 3a on both sides. By the electro-etching method of the present disclosure, the structures 3b are electrically isolated by removing the electrically conductive material on the surfaces 3a. Thereby, the connection for creating a potential is broken and the electro-etching stops automatically, preventing further etching of the material on or inside the structures 3b. This is shown on the right hand side of Figure 2 by dotted lines. The material layer on the structures 3b is only reduced, but the material forming the structures 3b remain unetched.

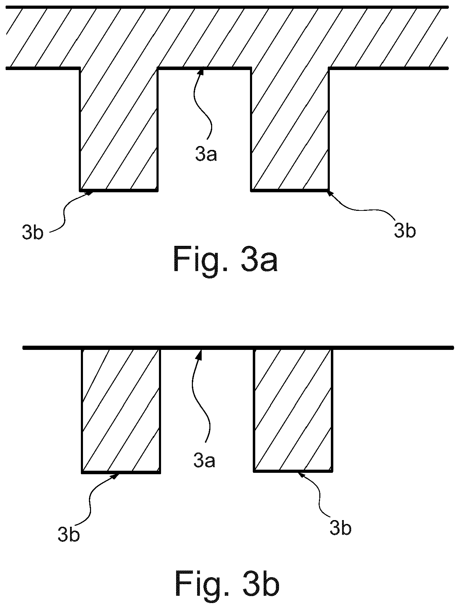

**Figures 3a and 3b** show schematically and exemplarily an embodiment of a substrate 3 during application of the electro-etching method for an area-selective treatment of a substrate 3 according to the present disclosure.

More specifically, Figure 3a shows schematically and exemplarily an embodiment of a substrate 3 comprising a surface 3a and vias or trenches as structures 3b. The structures 3b are kind of blind holes or blind vias. Nevertheless, the structure 3b may also have a shape extending in the +Z direction of the surface 3a of the substrate 3. This is not shown in the figures. In Figure 3a, the structures 3b are connected by the surface 3a. An electrically conductive material covers the structures 3b as well as the surface 3a. Accordingly, the structures 3b are electrically connected to each other by means of the electrically conductive material covering the surface 3a.

Figure 3b shows the substrate 3 when the layers on the surface 3a constituting the electrically conductive material between the structures 3b are removed. In other words, the substrate 3 is shown when the electrically conductive layer on the surface 3a is removed till Z=0 is reached. By removing the conductive material until the Z=0 position, the structures 3b are isolated from each other. When the electrical potential is thereby interrupted, electro-etching cannot continue, terminating the electro-etching process at the structures 3b automatically. Accordingly, during the removal of the at least one electrically conductive material covering the surface 3a between the structures 3b, the at least one electrically conducting material in or on the structures 3b is only reduced but not completely removed.

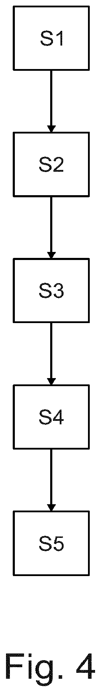

**Figure 4** shows schematically and exemplarily an embodiment of an electro-etching method for an area-selective treatment of a substrate 3 according to the disclosure.

The method comprises the steps of:
S1: providing a substrate 3 comprising a surface 3a and structures 3b. The surface 3a is at least partially covered by at least one electrically conductive material. The structures 3b are at least partially formed by the electrically conductive material, so that the structures 3b are electrically connected by means of the electrically conductive material covering the surface 3a;
S2: covering the substrate 3 with an electrolyte;
S3: applying an electric potential to the substrate 3;
S4: electro-etching the electrically conductive material by means of a combination of the electric potential and the electrolyte, and
S5: continuing the electro-etching until the electrically conductive material at the surface 3b is removed so that the structures 3b are no longer electrically connected by means of the electrically conductive material covering the surface 3a.

It has to be noted that embodiments of the disclosure are described with reference to different subject matters. In particular, some embodiments are described with reference to method type claims whereas other embodiments are described with reference to the device type claims. However, a person skilled in the art will gather from the above and the following description that, unless otherwise notified, in addition to any combination of features belonging to one type of subject matter also any combination between features relating to different subject matters is considered to be disclosed with this application. However, all features can be combined providing synergetic effects that are more than the simple summation of the features.

While the disclosure has been illustrated and described in detail in the drawings and foregoing description, such illustration and description are to be considered illustrative or exemplary and not restrictive. The disclosure is not limited to the disclosed embodiments. Other variations to the disclosed embodiments can be understood and effected by those skilled in the art in practicing a claimed disclosure, from a study of the drawings, the disclosure, and the dependent claims.

In the claims, the word "comprising" does not exclude other elements or steps, and the indefinite article "a" or "an" does not exclude a plurality. A single processor or other unit may fulfil the functions of several items re-cited in the claims. The mere fact that certain measures are re-cited in mutually different dependent claims does not indicate that a combination of these measures cannot be used to advantage. Any reference signs in the claims should not be construed as limiting the scope.

## Claims

1. An electro-etching method for an area-selective treatment of a substrate (3), comprising:
- providing a substrate (3) comprising a surface (3a) at least partially covered by at least one electrically conductive material and structures (3b) at least partially formed by the electrically conductive material, so that the structures (3b) are electrically connected by means of the electrically conductive material covering the surface (3a),
- covering the substrate (3) with an electrolyte,
- applying an electric potential to the substrate (3),
- electro-etching the electrically conductive material by means of a combination of the electric potential and the electrolyte, and
- continuing the electro-etching until the electrically conductive material at the surface (3a) is at least partially removed so that the structures (3b) are no longer electrically connected by means of the electrically conductive material covering the surface (3a).

2. The method according to claim 1, wherein the structures (3b) are trenches at least partially filled by the electrically conductive material and/or ridges comprising the electrically conductive material.

3. The method according to one of the preceding claims, wherein the electro-etching is essentially stopped with the removal of the at least one electrically conductive material covering the surface (3a) between the structures (3b).

4. The method according to one of the preceding claims, wherein the electrically conductive material covering the surface (3a) of the substrate (3) is the same as the electrically conductive material forming the structures (3b).

5. The method according to one of the preceding claims, wherein the electric potential extracts electrons from the electrically conductive material to electrically oxidize the electrically conductive material to obtain an electrically oxidized material surface.

6. The method according to one of the preceding claims, wherein the electrolyte dissolves the electrically oxidized material surface.

7. The method according to one of the preceding claims, wherein an availability of the electrolyte is reduced in areas of high electromagnetic field (11) to balance the electro-etching relative to areas of lower electromagnetic field (10).

8. The method according to one of the preceding claims, wherein the electrolyte is not chemically oxidizing the electrically conductive material.

9. The method according to one of the preceding claims, wherein the electrolyte is passivating the electrically conductive material forming the structures (3b) after the electrically conductive material covering the surface (3a) between the structures (3b) has been removed.

10. An electro-etching system for an area-selective treatment of a substrate (3), comprising:
- an substrate holder (1) configured to hold the substrate (3) and provide an electric potential to the substrate (3) to form an anode,
- a cathode,
- an electrolyte configured to cover the substrate holder (1),
- a distribution body comprising electric potential distribution vias to distribute the electric potential relative to the substrate holder (1) and chemical dissolution distribution vias to distribute the electrolyte relative to the substrate holder (1) to electro-etch at least one electrically conductive material covering at least partially at a surface (3a) of the substrate (3) and forming at least partially structures (3b) of the substrate (3) by means of a combination of the electric potential and the electrolyte.

11. The system according to claim 10, wherein the substrate holder (1) is electrically connected to a positive pole of a source of direct electric current and/or wherein the cathode is electrically connected to a negative pole of the source of direct electric current.

12. The system according to one of the claims 10 to 11, wherein the cathode is made of an inert material and/or a material insoluble in the electrolyte.

13. The system according to one of the claims 10 to 12, wherein the substrate holder (1) comprises a plurality of electric contacts for the substrate (3).

14. The system according to one of the claims 10 to 12, wherein the substrate holder (1) comprises one electric contact for the substrate (3) and is of the same size as the substrate (3).

15. The system according to one of the claims 10 to 14, wherein the chemical dissolution distribution vias comprise jet holes for controlling a flow of the electrolyte towards the substrate holder (1).

16. The system according to one of the claims 10 to 15, wherein the chemical dissolution distribution vias comprise drain holes for controlling a draining off the electrolyte from the substrate holder (1).

17. The system according to the preceding claim, wherein the electric potential distribution vias are the drain holes.

18. The system according to one of the claims 10 to 17, further comprising a netted distribution framework arranged between the distribution body and the substrate holder (1), wherein the netted distribution framework comprises passages as electric potential distribution vias to distribute the electric potential relative to the substrate holder (1) and chemical dissolution distribution vias to distribute the electrolyte relative to the substrate holder (1).

19. The system according to one of the claims 10 to 18, wherein a distance between the substrate holder (1) and the distribution body or the netted distribution framework is in a range of 5 to 50 mm, preferably 8 to 45 mm, more preferably 10 to 40 mm.
